# DEMANDE DE BREVET EUROPEEN

(11) **EP 0 564 355 A1**
(43) Date de publication de la demande: **06.10.1993**
(21) Numéro de dépôt: 93400831.9
(22) Date de dépôt: 31.03.1993
(51) Int. Cl.: H04B 10/14, H01S 3/00

(54) **Photorécepteur pour signaux optiques modulés en fréquence**

(30) Priorité: 02.04.1992 FR 9204005
(71) Demandeur: FRANCE TELECOM, F-75015 Paris (FR)
(72) Inventeur: Chawki, Mouhammad Jamil, F-22300 lannion (FR); Le Guiner, Loic, F-29750 Loctudy (FR); Dumay, Daniel, F-78120 Rambouillet (FR)
(74) Mandataire: Signore, Robert

(57) **Abrégé**

Ce photorécepteur est constitué d'un laser à semiconducteur (40) du type FABRY-PEROT (41, 42), dont l'une des faces (41) est traitée anti-reflet, avec des moyens (E, C, 44) pour prélever la tension aux bornes du laser.

Application en télécommunications optiques.

## Description

La présente invention a pour objet un photorécepteur pour signaux optiques modulés en fréquence. Elle trouve une application en télécommunications optiques.

### Etat de la technique antérieure

Parmi les divers types de modulation employés pour les signaux optiques, la modulation dite FSK (pour "Frequency Shift Keying") occupe une place privilégiée. Elle consiste à déplacer la fréquence du signal optique émis en fonction de l'information à transmettre. Cette modulation s'obtient aisément avec un laser à semiconducteur monofréquence en modulant le courant de polarisation.

La détection de signaux optiques modulés en FSK s'effectue généralement, soit par détection cohérente, soit par conversion directe en modulation d'intensité en utilisant un étalon FABRY-PEROT par exemple. La première méthode nécessite un oscillateur local (généralement constitué par un laser monofréquence accordable en longueur d'onde), un photodétecteur rapide, un mélangeur de signaux et des circuits électroniques complexes. Elle est donc difficile à mettre en oeuvre. La seconde ne l'est guère moins, nécessitant un circuit d'asservissement pour accorder l'une des fréquences de résonance de l'étalon à celle du signal à démoduler.

L'article de M.J. CHAWKI, R. AUFFRET et L. BERTHOU intitulé "1.5 Gbits/s FSK Transmission System Using Two Electrode DFB Laser as a Tunable FSK Discriminator/Photodetector" publié dans "Electronics Letters" 19^{th} July, 1990, vol. 26, n° 15, pp. 1146-1147, décrit un photorécepteur pour signaux optiques modulés en FSK, qui comprend un laser à rétroaction distribuée (en abrégé DFB pour "Distributed FeedBack") à deux électrodes. Ce laser est polarisé juste en dessous du seuil. Des moyens sont prévus pour prélever la variation de tension apparaissant aux bornes d'une des deux électrodes du laser récepteur. Cette variation de tension restitue l'information ayant servi à moduler le faisceau optique.

La demande de brevet FR-A-2 652 465 décrit un autre type de photorécepteur pour signaux optiques modulés en fréquence qui comprend encore un laser à semiconducteur, mais qui est cette fois alimenté au-dessus du seuil laser. On prélève encore la variation de tension électrique aux bornes du laser. Mais, comme le courant d'alimentation est réglé à une valeur très supérieure au seuil, le laser fonctionne en oscillateur et possède une fréquence propre. La tension prélevée présente alors, par rapport à la tension propre prélevée en l'absence de faisceau injecté, une variation dont l'amplitude est proportionnelle à l'écart entre la fréquence du faisceau injecté et la fréquence propre du laser et dont le signe est celui dudit écart de fréquence. La modulation de fréquence du faisceau lumineux injecté est ainsi traduite directement en modulation d'amplitude de la tension prélevée aux bornes du laser.

Bien que donnant satisfaction à certains égards, ces dispositifs présentent encore l'inconvénient de nécessiter un réseau au-dessus de la couche active.

### Exposé de l'invention

La présente invention a justement pour but de remédier à cet inconvénient. A cette fin, elle préconise, toujours pour la réception de signaux modulés en fréquence, d'utiliser encore un laser à semiconducteur dont on prélève la variation de tension aux bornes, mais ce laser étant dépourvu de réseau gravé et utilisant un résonateur de FABRY-PEROT. Comme déjà indiqué, l'utilisation d'un étalon FABRY-PEROT pour démoduler un faisceau modulé en fréquence est connu en soi mais, dans l'antérieur, l'étalon utilisé était passif. Dans l'invention, le résonateur de FABRY-PEROT constitue le résonateur d'un laser à semiconducteur. Il est donc partie d'un dispositif actif. Naturellement, les lasers semiconducteurs de type FABRY-PEROT sont eux-aussi connus, mais en tant que générateur à fréquence fixe et non comme photorécepteurs de faisceau optique modulé en fréquence. Par ailleurs, l'invention prévoit une modification du laser FABRY-PEROT classique, qui consiste à recouvrir l'une des faces par un revêtement anti-réfléchissant. Ce traitement diminue la finesse des pics du laser FABRY-PEROT et autorise un fonctionnement sur les parties quasi-linéaires des flancs de ces pics. Ce traitement augmente naturellement les pertes optiques du résonateur, ce qui doit être compensé électriquement par une alimentation de la structure semiconductrice largement au-dessus du seuil. Par exemple, on alimente le laser en courant environ trois fois au-dessus du seuil.

De façon précise, la présente invention a donc pour objet un photorécepteur pour signaux optiques modulés en fréquence, ce photorécepteur comprenant un laser à semiconducteur avec sa couche active, une source de courant de polarisation alimentant le laser au-dessus du seuil, des moyens optiques pour injecter un faisceau lumineux modulé en fréquence dans la couche active du laser, des moyens pour prélever la variation de tension électrique aux bornes du laser, ce photo-récepteur étant caractérisé par le fait que le laser comprend un résonateur de type FABRY-PEROT avec une première face recouverte d'un revêtement anti-réfléchissant et recevant le faisceau lumineux modulé en fréquence.

La seconde face peut être soit non traitée, soit recouverte par un revêtement réfléchissant. Ce revêtement peut comprendre une ou plusieurs couches.

Par courant de seuil, on entend ici le courant de seuil mesuré avant le traitement antiréfléchissant.

### Brève description des dessins

- la figure 1 montre le facteur de transmission d'un résonateur de FABRY-PEROT en fonction du coefficient de réflexion ;
- la figure 2 montre le spectre d'un laser à semiconducteur à FABRY-PEROT à faces réfléchissantes ;
- la figure 3 montre le même spectre mais avec une face traitée par une couche anti-reflet ;
- la figure 4 illustre un montage permettant de tester le photorécepteur de l'invention ;
- la figure 5 montre la réponse en fréquence du photorécepteur de l'invention ;
- la figure 6 représente le taux d'erreurs en fonction de la puissance reçue.

### Exposé détaillé d'un mode de réalisation

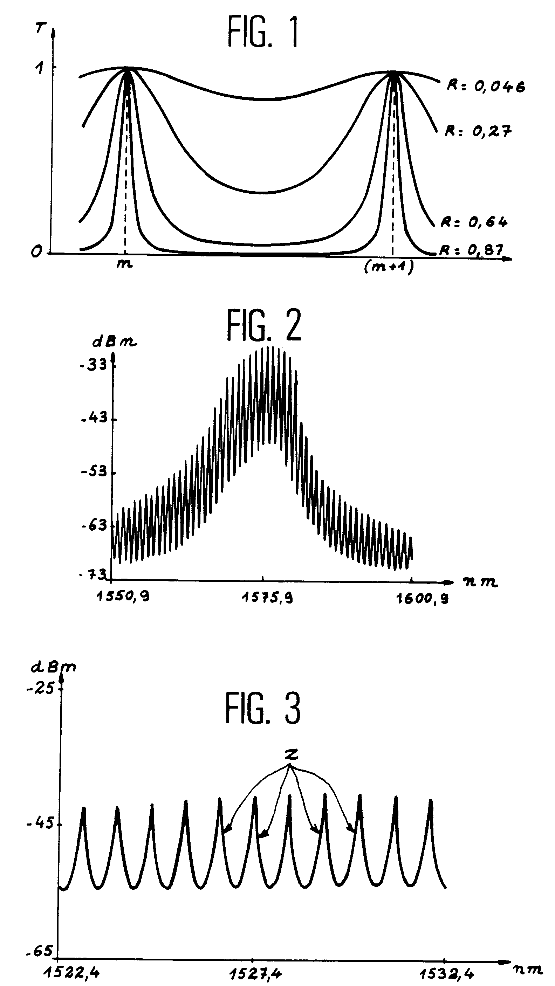

On voit, sur la figure 1, le taux de transmission T d'un résonateur FABRY-PEROT en fonction du coefficient de réflexion R de ses faces. Cette courbe est périodique en fréquence et définit différents modes longitudinaux m, m+1, etc...

La résonance est d'autant moins surtendue que le coefficient de réflexion est plus faible. Ce coefficient est porté sur les diverses courbes représentées.

Sur la figure 2, on voit le spectre d'un laser à semiconducteur utilisant un résonateur de FABRY-PEROT classique. Sur l'axe des abscisses est portée la longueur d'onde (en l'occurrence de 1550,9 nm à 1600,9 nm. En ordonnées figure l'intensité exprimée en dBm (décibels rapportés à 1 milliwatt).

Sur la figure 3 est représenté le spectre d'un laser utilisé comme photorécepteur conformément à l'invention. La face d'entrée du laser FABRY-PEROT a été recouverte par une couche anti-reflet qui a fait tomber le coefficient de réflexion de cette face par exemple à environ 10⁻⁵ (au lieu de 33% pour une face sans traitement). La plage de fréquence va de 1522,4 nm à 1532,4 nm. L'une quelconque des zones marquées Z, situées sur le flanc de ces pics, peut être utilisée pour faire de la démodulation de fréquence.

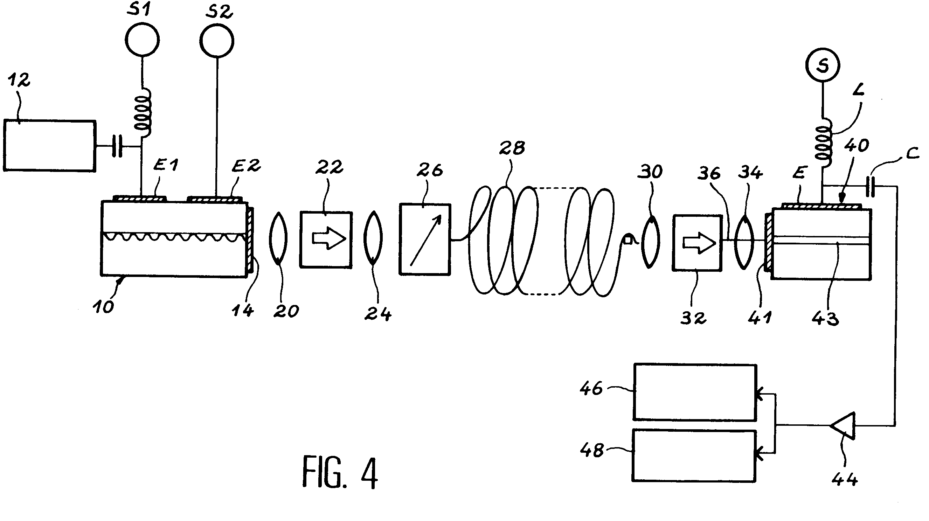

La figure 4 représente un banc permettant de tester le photorécepteur de l'invention. Tel que représenté ce banc comprend tout d'abord une source optique monofréquence accordable en longueur d'onde et modulée en fréquence. Cette source peut être un laser DFB (par exemple de structure "Buried Ridge Stripe") dont l'électrode d'alimentation a été séparée en deux électrodes E1 et E2 reliées à deux sources de courants S1 et S2. Un générateur de signaux 12 permet de moduler la fréquence de ce laser. La longueur de la cavité peut être de 425 µm, avec une face 14 traitée anti-reflet à 2%.

Le banc comprend encore des moyens optiques comme un objectif de microscope 20, pour collimater le faisceaux émis par le laser 10, un isolateur 22 (isolation de 38 dB à 1,52 µm), afin d'éliminer les réflexions qui perturberaient le fonctionnement du laser 10, un second objectif 24 pour coupler la lumière dans le coeur d'une fibre monomode et un atténuateur optique variable 26.

Ces moyens permettent d'injecter le faisceau modulé en fréquence dans une fibre optique 28.

Côté réception, on trouve encore divers moyens optiques comme un premier objectif de microscope 30, un isolateur 32, un second objectif de microscope 34 permettant d'injecter le faisceau optique 36 dans la couche active du photorécepteur.

Le photorécepteur, référencé 40, comprend une face avant 41 traitée par un revêtement antiréfléchissante et une face arrière réfléchissante, une couche active 43, une électrode E reliée à une source de polarisation S, des moyens pour prélever la variation de tension aux bornes de l'électrode E. Ces moyens peuvent être constitués par un té de polarisation avec un condensateur de couplage C relié à un amplificateur 44 (par exemple de 55 dB). L'amplificateur peut alimenter un analyseur de spectre 46 et un compteur d'erreurs 48.

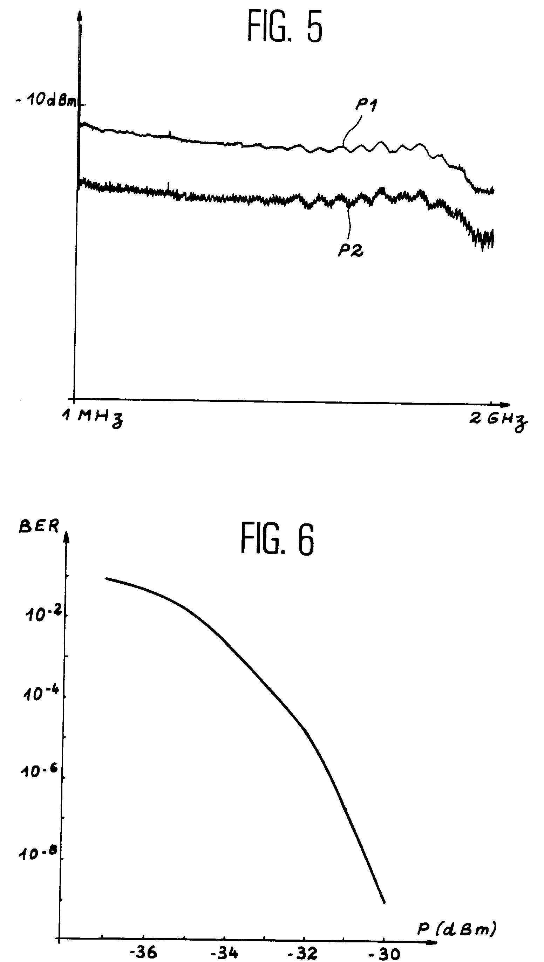

La figure 5 montre la réponse en fréquence mesurée de 1 MHz à 2 GHz avec ce banc pour deux puissances optiques injectées, respectivement P₁=-30 dBm et P₂=-33 dBm. La modulation de courant appliqué sur l'électrode du laser DFB était égale à 4 mA crête-crête, conduisant à une excursion de fréquence de 2 GHz. Cette courbe de réponse en fréquence présente une partie relativement plate jusqu'à 2 GHz.

La limitation du débit de transmission était imposée par la réponse en fréquence du laser DFB émetteur.

Pour une transmission à 1,5 GBit/s, avec un code (2⁻¹⁵-1)NRZ (Non Retour à Zéro), la courbe du taux d'erreur BER en fonction de la puissance reçue P(dBm) est celle de la figure 6.

On remarque qu'un taux d'erreur égal à 10⁻⁹ est obtenu pour une sensibilité du système égale à -30 dBm.

## Revendications

1. Photorécepteur pour signaux optiques modulés en fréquence, comprenant un laser à semiconducteur (40) avec sa couche active, une source de courant de polarisation (S) alimentant le laser (40) au-dessus du seuil, des moyens optiques (30, 32, 34) pour injecter un faisceau lumineux modulé en fréquence dans la couche active du laser, des moyens (C, 44) pour prélever la variation de tension électrique aux bornes (E) du laser (40), ce photorécepteur étant caractérisé par le fait que le laser comprend un résonateur de type FABRY-PEROT (41, 42) avec une première face (41) recouverte d'un revêtement anti-réfléchissant et recevant le faisceau lumineux modulé en fréquence.

2. Photorécepteur selon la revendication 1, caractérisé par le fait que le laser comprend une seconde face non recouverte par un revêtement réfléchissant.

3. Photorécepteur selon la revendication 1, caractérisé par le fait que le laser comprend une seconde face recouverte d'un revêtement réfléchissant.

4. Photorécepteur selon la revendication 1, caractérisé par le fait que le courant de polarisation est réglé à environ trois fois le courant de seuil.
